# EUROPEAN PATENT SPECIFICATION

(11) **EP 0 344 925 B1**
(45) Date of publication and mention of the grant of the patent: **03.08.1994**
(21) Application number: 89304595.5
(22) Date of filing: 05.05.1989
(51) Int. Cl.: H03K 19/195, H03K 19/094, H03K 17/92

(54) **Superconductively loaded semiconductor logic device**
Logische Halbleitervorrichtung mit supraleitender Ladung
Dispositif logique semi-conducteur à charge supraconductrice

(30) Priority: 02.06.1988 US 201662
(43) Date of publication of application: 06.12.1989
(73) Proprietor: TEXAS INSTRUMENTS INCORPORATED, Dallas Texas 75265 (US)
(72) Inventor: Taddiken, Albert H., Dallas Texas 75231 (US); Yuan, Han-Tzong, Dallas Texas 75240 (US)
(74) Representative: Abbott, David John

## Description

### FIELD OF THE INVENTION

The present invention relates in general to digital circuitry and, more particularly, to superconductively loaded devices for improving circuit performance.

### BACKGROUND

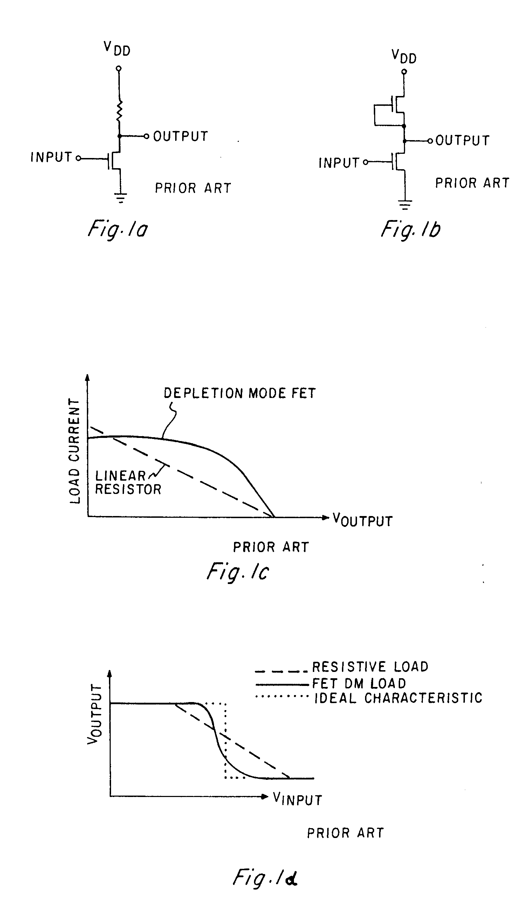

While fast switching devices are essential for high speed digital circuits, the quality of a switching circuit, that is noise margin, power consumption and layout density, is largely determined by the load device. In the past, both two terminal and three terminal load devices have been widely used in digital logic and memory circuitry. Figures 1A and 1B illustrate simple inverter circuits A and B having two terminal resistive and three terminal non-linear FET loads, respectively. In these examples a signal is input through a node to the gate of an enhancement mode switching transistor. Figure 1C illustrates the load line characteristic for circuits A and B. The nonlinear load is exemplified for a depletion mode field effect transistor (FET_{DM}).

The resistor of circuit A provides a charging current which decreases linearly as the output voltage increases. Hence the response time for the circuit of Figure 1A is relatively slow. Furthermore, for a given load resistance the linear device also provides an undesirably small noise margin compared to that which results when a depletion mode transistor is used as the load device.

Figure 1D presents in qualitative form the transfer characteristics for the inverter circuits A and B. The characteristic for circuit A, which utilizes a resistive load, is represented by a dashed curve and the characteristic for circuit B, which utilizes the FET_{DM} as a load device is represented by the solid line. An ideal transfer characteristic is illustrated with a dotted line.

Although the FET_{DM} load inverter circuit B more closely approximates ideal transfer characteristics than does circuit A, the transistor load will provide a relatively constant charging current only when the source/drain conductivity is relatively low compared to that of the input transistor and when the current level through the FET_{DM} declines sharply as conduction through the input transistor is cut off. This requires the FET_{DM} to operate substantially beyond the knee voltage, i.e. in the saturated region, which is at least 0.5 volt for a GaAs FET and 1.5 volts for a silicon FET. Furthermore, the FET_{DM} is normally used as a three terminal load device, requiring considerably more surface area than a two terminal device. Although a two terminal device can be formed with an FET_{DM}, e.g., by simply omitting the ohmic contact between gate and source electrodes, in order to reduce space requirements on a circuit structure, such an economy is known to result in lesser device performance. For example, on an integrated circuit comprising multiple two terminal FET_{DM} load devices there has been inadequate control in the uniformity of saturation currents among the several devices. Furthermore, for a given channel length significantly higher source/drain voltages would be required to operate a two terminal MOSFET in a nonlinear region in order to achieve desirable transfer characteristics.

If a two terminal non-linear load device could be formed with a low knee voltage and a load line characteristic like an FET_{DM}, then considerable improvement in the power and density of integrated logic circuitry can be achieved without sacrificing switching speed and noise margin.

### SUMMARY OF THE INVENTION

According to the present invention there is provided a circuit adapted for use at or below superconducting temperature T_{c} including a first logic inverter comprising:
an input transistor device having an electrode for receiving an input signal, a first terminal for connection to a reference potential and a second terminal for providing an output signal; and
a load device formed of superconductive material, positioned between the second terminal and a connection point for receiving a second voltage potential, the superconductive material having a characteristic critical current density J_{c} wherein in use the load device is operable as a linear load when conducting a current density in excess of J_{c} and the device is operable in a superconducting state below J_{c} and wherein the current density J exceeds J_{c} in response to the input signal reaching a predetermined level.

Recently several oxide ceramic compounds have been identified which possess superconductive properties at temperatures above the boiling point of nitrogen. Development of such materials is of great interest because nitrogen is a relatively inexpensive and abundant coolant. With the advent of ceramic oxide superconductors and the potential for developing materials which superconduct at even higher temperatures, the application of superconductive materials to integrated circuitry now offers the potential for higher levels of integration and lower energy dissipation.

### BRIEF DESCRIPTION OF THE DRAWING

The invention may best be understood by reference to the following detailed description of illustrative embodiments when read in conjunction with the accompanying drawing, wherein:
Figures 1A - 1D illustrate prior art inverter circuits and associated characteristic curves;
Figure 2 illustrates an inverter circuit comprising a switchable load device formed with superconductive material;
Figure 3 presents a current - voltage characteristics for the load device of Figure 2;
Figure 4 illustrates a load line curve and a family of transistor output curves;
Figure 5 is a partial schematic view of a static random access memory cell;
Figure 6 illustrates an ECL logic gate;
Figure 7 illustrates a buffered FET logic gate;
Figure 8 illustrates a NAND logic gate; and
Figure 9 illustrates a NOR logic gate.

Identical reference numerals are employed in various figures refer to the same components.

### DESCRIPTION OF THE PREFERRED EMBODIMENTS

Although certain preferred embodiments are described herein, it should be appreciated that the present invention is applicable to a wide variety of circuits. Specific materials and processes for forming the circuits as discussed herein are merely illustrative and do not delimit the scope of the invention.

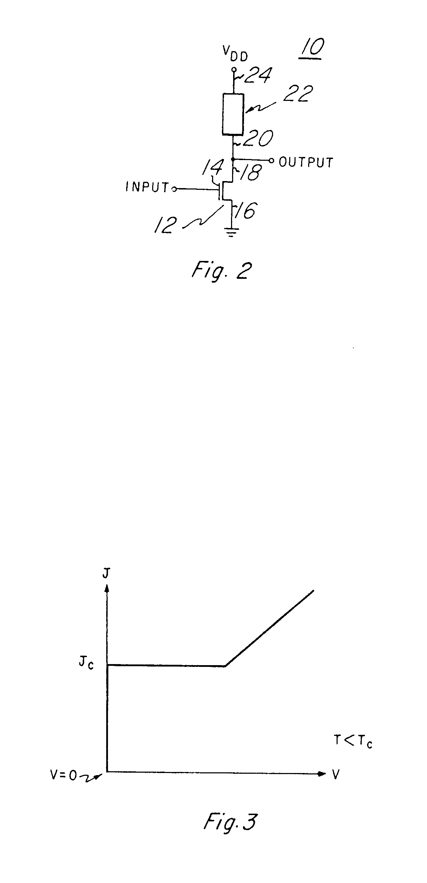

Figure 2 illustrates an inverter circuit 10 wherein a superconductor provides a switchable load resistance at temperatures below T_{C}. The circuit comprises an input transistor 12, which, in this exemplary embodiment is a MOSFET having a gate electrode 14 for receiving an input signal, a first source/drain electrode 16 coupled to a ground potential and a second source/drain electrode 18. The input transistor type is not limited to MOSFETs. Bipolar transistors, GaAs MESFETs and high electron mobility transistors (HEMTs) are, for example, a few of the well known transistor types which may be used in lieu thereof.

The second transistor electrode 18 is coupled to one terminal 20 of a superconductive load device 22. In a preferred form of the invention the load device 22 is a passive element comprising a filament of superconductive material such as, for example, YBa₂Cu₃Oₓ, and having a critical transition temperature T_{C} near or above the boiling point of liquid nitrogen, i.e., 77K. A second terminal 24 of the device 22 is coupled to a voltage source V_{DD}.

Figure 3 presents the current - voltage characteristics for the superconductive device 22 when performing below the critical temperature T_{C}. When the current density J is also below a critical level J_{C} the device operates in a superconducting state which exhibits no resistance and therefore no voltage drop results as current density increases up to a critical value J_{C}. At current densities near J_{C} the device begins transitioning to a normal conductivity state.

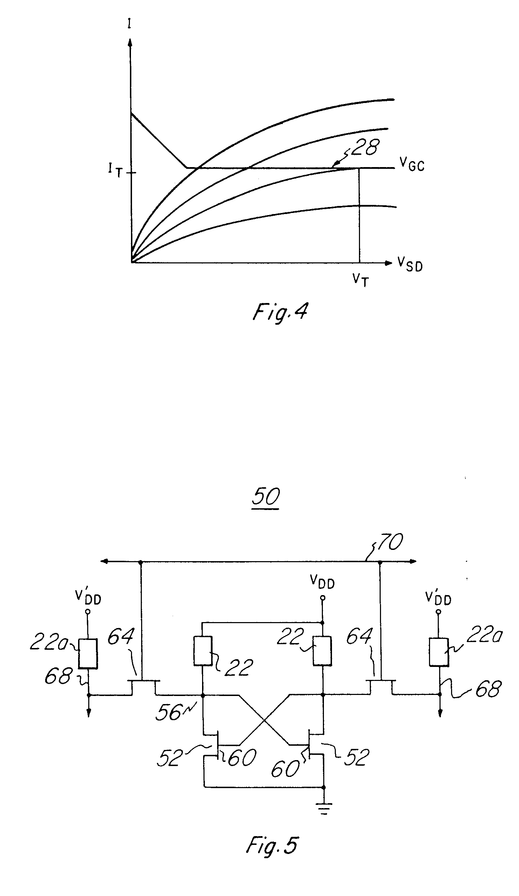

The qualitative transition curve exhibited in Figure 3, while believed to be representative for some materials, is not intended to exemplify such transitions generally. Rather, the precise current - voltage transition which occurs about J_{C} is believed to be dependent upon the type of superconductor material and the crystal quality. Above J_{C} the device operates in a normal conductivity state and conducts current as a linear function of voltage. Based on these properties Figure 4 illustrates the corresponding load line curve 28 and a family of output characteristic curves for the input transistor 12 of Figure 2. The output curves illustrate the relationship between the level of current conducted through the transistor 12 and the transistor source/drain voltage for various values of gate voltage V_{G}.

At a superconducting temperature and up to a threshold current level I_{T} the load device 22 operates in the superconducting state. Therefore, as V_{G} increases from zero to near a transition level V_{GC}, the load device 22 behaves like a perfect conductor and the total voltage drop V_{DD} is across the input transistor 12. Near V_{GC} a threshold current I_{T} is attained, and the load device 22 abruptly shifts to the normal conductivity state as exhibited by the nearly horizontal voltage shift shown in Figure 4. Above I_{T} the device 22 exhibits behavior analogous to the resistive load of prior art circuit A, i.e., current through the device increases directly with V_{G} and indirectly with the source/drain voltage V_{SD} across the input transistor 12.

For example, a relatively low value of I_{T} will cause the superconductive load device 22 to operate as an ohmic conductor for small values of V_{G}, this providing a relatively small noise margin, albeit a sufficiently low "logic low" output voltage for input to a subsequent logic stage. On the other hand, selecting a relatively high value of I_{T}, e.g., close to the saturation current level of the input transistor 12, will result in a larger noise margin - provided that the "logic low" output voltage is sufficiently low for input to a subsequent logic stage.

The threshold current I_{T} may be adjusted to a desired value by varying the cross sectional area of the filament of superconductive material from which the device 22 is formed. It may also be necessary or desirable to alter the critical current density J_{C} of the superconductive material. In this regard see Gallagher et al., Mat. Res. Bull., Vol. 22, pp. 995 - 1006, 1987; and Cava, et al., Nature, Vol. 329, pp. 423 - 427, October 1, 1987, each hereby incorporated by reference.

The Gallagher study suggests that lattice structures of cuprate ceramics are dependent on the degree and nature of oxidation in the material. Cava et al. indicate that both superconducting and normal state properties are dependent on the microscopic distribution of oxygen. Generally, the attainment of a specific, uniform stoichiometry is regarded as a key to optimum material characteristics such as J_{C} for a variety of superconducting materials.

Furthermore, at least a few of the classes of materials which can be formed into superconductors are subject to the relatively volatile nature of component oxygen during thermal processing, e.g., at temperatures higher than 400C for YBa₂Cu₃Oₓ. To counter this effect thermal processing steps to form crystals of the materials are often conducted in an oxygen rich environment. Nevertheless, the structures typically contain insufficient oxygen levels to exhibit desired characteristics. Therefore, a step which has been common to many, if not all, processing sequences for making superconductive ceramic oxide materials, is a lengthy anneal to drive additional oxygen atoms into the ceramic and attain the desired stoichiometry.

Another parameter affecting the superconductive features of many cuprate ceramics is the nonhomogeneous nature of the synthesized materials. Therefore, processing steps are often required to alter the distribution of atoms as well as to correct macroscopic oxygen deficiencies.

From the above discussion it is apparent that various grades of oxide ceramic superconductors may be developed based on the processing sequences employed. For example, when the starting material is a powder, substantial oxygen deficiencies are known to result when individual grains are thermally fused together. If the fused material is melted and recrystallized, e.g., at 1300°C, the oxygen deficiency is expected to be even more severe. Alternatively, when the material is formed by deposition on a crystalline substrate, e.g., by sputtering under a partial pressure of oxygen, thermal processing can be performed in an oxygen atmosphere to correct lattice inhomogeneities while preventing further loss of the oxygen.

Multiple grades of superconductive material can be formed on the same substrate by patterning techniques and by selectively forming cap layers over the oxide ceramic in order to isolate portions of the ceramic material from processing steps.

It is noted that oxygen implantation for purposes other than ocrrecting the stoichiometry of ceramic material, e.g., for intentionally damaging a superconductive material, have been reported. See Clark et al., "Effects of Radiation Damage in Ion-implanted Thin Films of Metal-Oxide Superconductors", Appl. Phys. Lett., 51 (2), 13 July 1987, pp. 139 - 141; and see Koch et al., "Quantum Interference Devices Made From Superconducting Oxide Thin Films", Appl. Phys. Lett., 51 (3), 20 July 1987, pp. 200 - 202, each herein incorporated by reference.

The Clark and Koch papers address degrading portions of superconducting films from their superconducting structures, e.g., for patterning interconnect lines. They disclose implantation energies for beams of oxygen or arsenic ranging from 0.25 - 2.3 MeV into films which vary from 0.5 to 1.5 microns. Some of the disclosed film compositions approximate YBa₂Cu₃Oₓ. To the extent that the papers report thorough conversion of low grade polycrystalline superconductor material to an insulator, oxygen implants ranging from 0.25 - 1 MeV appear satisfactory for selectively patterning and degrading portions of a ceramic oxide film on the order of one micron thick. Thus the device 22 may be formed by altering select regions of the film to have a lower J_{C} than other film regions.

As another alternative, after optimum stoichiometry is reached, e.g., x = 6.98 approximately, for YBa₂Cu₃Oₓ, portions of the film may be selectively degraded by oxygen removal during a high temperature anneal. Other portions of the film to be retained as higher quality superconductor, e.g., for interconnect, would be covered with a cap layer to preserve optimum oxygen stoichiometry. After two or more regions having different compositions are formed they may be masked, patterned and implanted to delineate superconductive interconnects and devices by known methods such as those described by Koch et al.

It is also possible to simultaneously pattern interconnect lines and the device 22 when correcting the oxygen content to the desired level by ion implantation. This may be accomplished by selectively patterning a ceramic oxide film with material of fluctuating thickness to vary penetration of the oxygen into the film during oxygen implantation. Some patterned regions will remain highly resistive or nonconductive because they are completely isolated from the implant. Patterning material over other regions of the film will be of lesser thickness to permit some ion penetration into the film thus enabling those regions of the film to become superconductors, albeit poorer superconductors than portions of the film which are not patterned. As a result, there will be formed: a high quality, i.e. high J_{C}, superconductive region; a lesser quality, i.e., low J_{C}, superconductive region suitable for the device 22; and a highly resistive or nonconductive region for electrical isolation and delineation of the other regions.

By way of example, the patterning material may be a layer of gold film varying between zero and 0.5 micron, which will block oxygen implantation at energies ranging between 0.25 and 1 MeV. The gold layer may be patterned with an organic layer of photoresist which is then developed and selectively etched to expose regions corresponding to the desired interconnect pattern.

Other variations will be apparent to those skilled in the various technologies in which ceramic materials are utilized. Clearly the method may be modified to optimize various material characteristics of the ceramic. Furthermore, the method presented herein can be applied to form patterns of varying linewidth and thickness, including the conductive, resistive and insulative patterns.

### MODIFICATIONS AND ADVANTAGES OF THE INVENTION

Numerous circuit arrangements may be based on the two terminal load device 22 and circuit of Figure 2. These can result in higher levels of integration over three terminal devices without degrading circuit performance for at least two reasons. First, if the device 22 is formed on the same level of an integrated circuit structure as the input transistor 12, it will occupy less space than a FET_{DM} load because it requires only two electrode contacts. Second, since the device 22 is not formed with semiconductor material it can be patterned on a different level than the transistor 12, e.g., above the semiconductor devices.

Figure 5 illustrates in partial schematic view the formation of a static random access memory cell 50 based on the circuit of Figure 2 wherein two memory cell transistors 52 are arranged in parallel between nodes for receiving a voltage source V_{DD} and a reference potential. A superconductive load device 22 is arranged in series with each transistor 52 in a manner analogous to that described for the input transistor 12 of Figure 2. A node 56 between each transistor and its respective load device 22 is coupled to the gate electrode 60 of the other transistor 52. Each node 56 is also electrically connected to a first source/drain region of a pass transistor 64. The second source/drain region of each pass transistor is connected to a bit line 68. The gate of each pass transistor 64 is connected to a word line 70. Each bit line 68 also includes a superconductive load device 22A arranged to perform the function of a pull up transistor. Preferably the load device 22A will have a higher threhold current I_{T} than the load device 22. Other portions of the memory circuit are omitted for clarity.

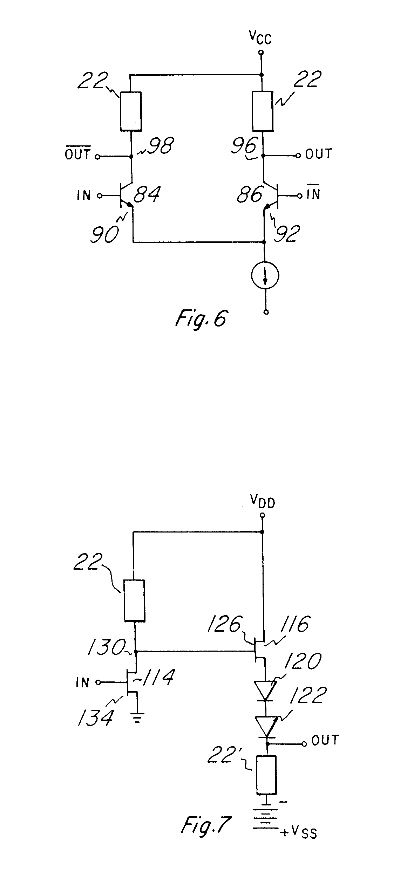

Figure 6 illustrates an ECL logic gate 80 based on the present invention wherein two NPN transistors 84 and 86 are arranged in a common emmitter configuration between collector output nodes and a common emmiter node. A superconductive load device 22 is arranged in series with each transistor 84 and 86, again in a manner analogous to that illustrated in Figure 2. An input signal IN is provided to the base 90 of transistor 84 and the inverse of the input signal is provided to the base 92 of the transistor 86. An output signal OUT is provided at a node 96 between the transistor 86 and its respective load device 22. An inverted output signal is available at a node 98 between the other transistor 84 and the other load device 22.

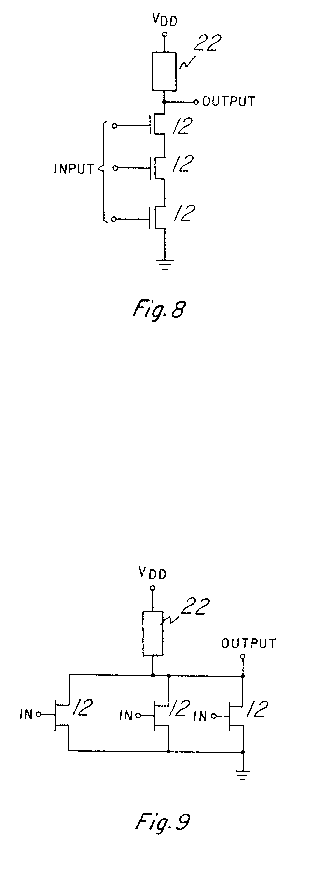

Figure 7 illustrates a buffered FET logic gate 100 incorporating principles of the present invention. The superconductive load device 22 is positioned in series with a depletion mode FET 114 to form a first branch between a positive voltage source V_{DD} and a reference potential. A second branch comprises a second depletion mode FET 116 connected in series between the source V_{DD} and a negative voltage source V_{SS}. A pair of diodes 120 and 122 and a second superconductive load device 22′ are serially connected between the transistor 116 and the source V_{SS}. The gate 126 of the second FET 116 is connected to a node 130 between the first FET 114 and the first load device 22. Input signals IN are provided to the gate 134 of the transistor 114 and output signals OUT are provided at a node 136 between the diode 122 and the second load device 22′. The logic gate 100 possesses the advantages described with regard to the circuit of Figure 2. In addition, the load device 22′ provides a relatively constant current between V_{DD} and V_{SS} through the second branch. Preferably the characteristics of the second load device 22′ will be different from those of the first device 22, i.e., I_{T} will be larger.

The circuit of Figure 8 is a NAND logic gate formed with the circuit of Figure 2 by adding additional input transistors 12 in serial connection between the voltage source V_{DD} and the ground potential. The circuit of Figure 9 is a NOR logic gate based on the circuit of Figure 2 and further comprising additional FET input transistors 12 coupled in parallel across the source/drain regions.

Certain preferred embodiments of the invention have been described. Various other arrangements and configurations of the disclosed embodiments and components thereof will be apparent when applying the invention to perform desired tasks and when optimizing parameters or minimizing power requirements. Accordingly the scope of the invention is only to be limited by the claims which follow.

## Claims

1. A circuit adapted for use at or below superconducting temperature T_{c} including a first logic inverter comprising:
an input transistor device having an electrode for receiving an input signal, a first terminal for connection to a reference potential and a second terminal for providing an output signal; and
a load device formed of superconductive material, positioned between the second terminal and a connection point for receiving a second voltage potential, the superconductive material having a characteristic critical current density J_{c} wherein in use the load device is operable as a linear load when conducting a current density in excess of J_{c} and the device is operable in a superconducting state below J_{c} and wherein the current density J exceeds J_{c} in response to the input signal reaching a predetermined level.

2. A circuit according to claim 1, wherein said input device has parameters matched to the critical current density such that J>J_{c} when the voltage of the input signal exceeds a predetermined value.

3. A circuit according to claim 1 or claim 2, wherein the input device is a transistor.

4. A circuit according to any preceding claim, wherein said input device is a field effect transistor with a gate region for receiving the input signal.

5. A circuit according to claim 3 or claim 4, wherein said transistor is a MOSFET.

6. A circuit according to claim 3 wherein said transistor is a bipolar transistor.

7. A circuit according to claim 3 or claim 4, wherein said transistor is a GaAs heterostructure transistor.

8. A circuit according to any preceding claim, wherein the superconductive material is a ceramic oxide.

9. A circuit according to any preceding claim, wherein the superconductive material comprises YBa₂CU₃Oₓ.

10. A circuit according to any preceding claim, further comprising a second logic inverter, the output of each inverter being connected to the input of the other to form a static memory cell.

11. A circuit according to claim 10, further comprising for each logic inverter:
a bit line coupled to the input device;
a pass transistor connected in a current path between the bit line and the input device; and
a word line connected to control current flow through each pass transistor, so that the circuit is a random access memory cell.

12. A circuit according to any one of claims 3 to 9 further comprising one or more additional input devices having source/drain regions connected in series with said load device to form a NAND gate.

13. A circuit according to any one of claims 3 to 9, further comprising one or more additional input devices, said devices being coupled in parallel across source/drain regions to form an NOR gate.

14. A circuit according to any preceding claim, wherein said superconductive device is a two terminal device.

## Patentansprüche

1. Für die Anwendung bei oder unterhalb einer supraleitenden Temperatur T_{c} geeignete Schaltung mit einem ersten Logikinverter, enthaltend:
eine Eingangstransistorvorrichtung mit einer Elektrode für den Empfang eines Eingangssignals, einem ersten Anschluß zum Verbinden mit einem Referenzpotential und einem zweiten Anschluß zur Abgabe eines Ausgangssignals; und
eine Lastvorrichtung aus supraleitendem Material, die zwischen dem zweiten Anschluß und einem Verbindungspunkt für den Empfang eines zweiten Spannungspotentials angeschlossen ist, wobei das supraleitende Material eine charakteristische kritische Stromdichte J_{c} aufweist, wobei die Lastvorrichtung bei der Anwendung als lineare Last betrieben werden kann, wenn sie eine Stromdichte größer als J_{c} leitet, und in einem supraleitenden Zustand unterhalb von J_{c} betrieben werden kann, und wobei die Stromdichte J den Wert J_{c} abhängig davon überschreitet, daß das Eingangesignal einen vorbestimmten Wert erreicht.

2. Schaltung nach Anspruch 1, bei welcher die Eingangsvorrichtung Parameter aufweist, die an die kritische Stromdichte angepaßt sind, so daß J > J_{c} ist, wenn die Spannung des Eingangssignals einen vorbestimmten Wert überschreitet.

3. Schaltung nach Anspruch 1 oder Anspruch 2, bei welcher die Eingangsvorrichtung ein Transistor ist.

4. Schaltung nach einem der vorhergehenden Ansprüche, bei welcher die Eingangsvorrichtung ein Feldeffekttransistor mit einer Gate-Zone für den Empfang des Eingangssignale ist.

5. Schaltung nach Anspruch 3 oder Anspruch 4, bei welcher der Transistor ein MOSFET ist.

6. Schaltung nach Anspruch 3, bei welcher der Transistor ein bipolarer Transistor ist.

7. Schaltung nach Anspruch 3 oder Anspruch 4, bei welcher der Transistor ein GaAs-Transistor mit Heterostruktur ist.

8. Schaltung nach einem der vorhergehenden Ansprüche, bei welcher das supraleitende Material ein keramisches Oxid ist.

9. Schaltung nach einem der vorhergehenden Ansprüche, bei welcher das supraleitende Material YBa₂CU₃Oₓ enthält.

10. Schaltung nach einem der vorhergehenden Ansprüche, ferner enthaltend einen zweiten Logikinverter, wobei der Ausgang jedes Inverters mit dem Eingang des anderen verbunden ist, um eine statische Speicherzelle zu bilden.

11. Schaltung nach Anspruch 10, ferner enthaltend für jeden Logikinverter;
eine Bitleitung, die mit der Eingangsleitung gekoppelt ist;
einen Durchgangstransistor, der in einem Stromweg zwischen der Bitleitung und der Eingangavorrichtung liegt; und
eine Wortleitung, die so angeschlossen ist, daß sie den Stromfluß durch jeden Durchgangstransistor steuert, so daß die Schaltung eine Direktzugriffspeicherzelle ist.

12. Schaltung nach einem der Ansprüche 3 bis 9, ferner enthaltend eine oder mehrere zusätzliche Eingangsvorrichtungen mit Source/Drain-Zonen, die in Serie mit der Lastvorrichtung zur Bildung eines NAND-Gatters geschaltet sind.

13. Schaltung nach einem der Ansprüche 3 bis 9, ferner enthaltend eine oder mehrere zusätzliche Eingangsvorrichtungen, wobei diese Vorrichtungen parallel zu Source/Drain-Zonen geschaltet sind, um ein NOR-Gatter zu bilden.

14. Schaltung nach einem der vorhergehenden Ansprüche, bei welcher die supraleitende Vorrichtung ein Zweipol ist.

## Revendications

1. Circuit adapté à l'utilisation à une température égale ou inférieure à une température supraconductrice Tc comprenant un premier inverseur logique comportant :
un dispositif à transistor d'entrée ayant une électrode pour recevoir un signal d'entrée, une première borne pour la connexion à un potentiel de référence et une seconde borne pour fournir un signal de sortie; et
un dispositif de charge formé en matériau supraconducteur, placé entre la seconde borne et un point de connexion pour recevoir un second potentiel de tension, le matériau supraconducteur ayant une densité de courant critique caractéristique Jc de manière que lors de l'utilisation le dispositif de charge peut fonctionner comme une charge linéaire lorsqu'il conduit une densité du courant supérieure à Jc et le dispositif peut fonctionner dans un état supraconducteur au-dessous de Jc, et dans lequel la densité de courant J excède Jc lorsque le signal d'entrée atteint un niveau prédéterminé.

2. Circuit selon la revendication 1, dans lequel ledit dispositif d'entrée a des paramètres adaptés à la densité de courant critique de telle sorte que J>Jc lorsque la tension du signal d'entrée excède une valeur prédéterminée.

3. Circuit selon la revendication 1 ou la revendication 2, dans lequel le dispositif d'entrée est un transistor.

4. Circuit selon l'une quelconque des revendications précédentes, dans lequel ledit dispositif d'entrée est un transistor à effet de champ avec une région de grille pour recevoir le signal d'entrée.

5. Circuit selon la revendication 3 ou la revendication 4, dans lequel ledit transistor est un MOSFET.

6. Circuit selon la revendication 3 dans lequel ledit transistor est un transistor bipolaire.

7. Circuit selon la revendication 3 ou la revendication 4, dans lequel ledit transistor est un transistor à hétérostructure GaAs.

8. Circuit selon l'une quelconque des revendications précédentes, dans lequel le matériau supraconducteur est un oxyde de céramique.

9. Circuit selon l'une quelconque des revendications précédentes, dans lequel le matériau supraconducteur comporte du YBa₂Cu₃Oₓ.

10. Circuit selon l'une quelconque des revendications précédentes, comprenant en outre un second inverseur logique, la sortie de chaque inverseur étant connectée à l'entrée de l'autre pour former une cellule de mémoire statique.

11. Circuit selon la revendication 10, comprenant en outre pour chaque inverseur logique:
une ligne de bits couplée au dispositif d'entrée;
un transistor ballast connecté dans un trajet de courant entre la ligne de bits et le dispositif d'entrée; et
une ligne de mots connectée au trajet du courant de commande par l'intermédiaire de chaque transistor ballast, de telle sorte que le circuit constitue une cellule de mémoire à accès aléatoire.

12. Circuit selon l'une quelconque des revendications 3 à 9 comprenant en outre un ou plusieurs dispositifs d'entrée supplémentaires ayant des régions de source/drain connectées en série avec ledit dispositif de charge pour former une porte NON-ET.

13. Circuit selon l'une quelconque des revendications 3 à 9 comprenant en outre un ou plusieurs dispositifs d'entrée supplémentaires, lesdits dispositifs étant couplés en parallèle aux bornes des régions de source/drain pour former une porte NON-OU.

14. Circuit selon l'une quelconque des revendications précédentes, dans lequel ledit dispositif supraconducteur est un dispositif à deux bornes.
